(19) Europäisches Patentamt
European Patent Office
Office européen des brevets

(11) EP 4 571 807 A1

## (12) EUROPEAN PATENT APPLICATION

(43) Date of publication:
**18.06.2025 Bulletin 2025/25**

(21) Application number: 23216764.3

(22) Date of filing: **14.12.2023**

(51) International Patent Classification (IPC):
*H01H 47/00* (2006.01)          *H01H 47/32* (2006.01)

(52) Cooperative Patent Classification (CPC):
**H01H 47/002;** H01H 47/32; H01H 2047/006;
H01H 2047/009

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ABB Schweiz AG
5400 Baden (CH)**

(72) Inventors:
• **USAI, Roberto**
   **24048 Treviolo (IT)**
• **TESTA, Marco**
   **24058 Romano di Lombardia (IT)**
• **RIVA, Marco**
   **24040 Canonica D'Adda (IT)**

(74) Representative: **De Bortoli, Eros et al
Zanoli & Giavarini S.p.A.
Via Melchiorre Gioia, 64
20125 Milano (IT)**

## (54) SUPERVISOR UNIT FOR LOW AND MEDIUM VOLTAGE APPLICATIONS

(57)    The present invention relates to a supervisor unit configured to control a coil actuator operatively coupled to or included in a low or medium voltage switching apparatus.

The coil actuator comprises a coil electromagnet having a single coil winding and a movable member operatively coupled to suitable mechanical parts (e.g., a kinematic chain) of the switching apparatus.

The coil actuator further comprises a power circuit configured to drive the coil electromagnet upon receiving an input voltage to make the coil actuator carry out a launch and hold manoeuvre.

The coil actuator additionally comprises a controller configured to drive a switch circuit of the power circuit with a driving voltage in order to carry out a PWM control of an input current circulating through the above-mentioned power circuit when this latter received an input voltage in such a way that the coil electromagnet is fed with an excitation current.

The supervisor unit is in communication with the controller of the coil actuator and is configured to receive detection data indicative of a behaviour of electrical quantities of the coil actuator from the controller of the coil actuator.

The supervisor unit is configured to carry out a diagnostic procedure directed to provide diagnostic information related to the operating conditions of the coil actuator 1 based on the detection data received from the controller of the coil actuator.

Fig. 1

EP 4 571 807 A1

## Description

The present invention relates to a supervisor unit for low and medium voltage applications.

The supervisor unit of the invention is configured to provide advanced diagnostic functionalities related to the operating conditions of a coil actuator operatively coupled to or included in a low or medium voltage switching apparatus.

Coil actuators are frequently used in association to low or medium voltage switching apparatuses (e.g., circuit breakers, disconnectors, contactors, and the like) to release or lock mechanical parts of said switching apparatuses.

Most recent coil actuators (hereinafter referred to as "single coil actuators") have a coil electromagnet provided with a single coil winding and a driving electronics configured to control the energization of said coil electromagnet to actuate a movable member from a rest position to an actuated position and maintain said movable member in said actuated position (launch and hold manoeuvre).

An example of these coil actuators is described in EP2149890B1.

Most advanced single coil actuators are normally configured to communicate with a supervisor relay, which is typically configured to control their operation and carry out diagnostic tests to detect possible failures.

Unfortunately, the experience has shown how the diagnostic services provided by currently available supervisor relays are characterised by relatively poor levels of reliability.

Additionally, they generally provide just a limited information on the actual operating conditions of the coil actuator. As an example, a supervisor relay can determine whether there is an electric failure (e.g., the coil winding is interrupted) but it provides no information on possible on-going deterioration phenomena affecting the components of the coil actuator or whether the coil actuator is subject to performance drifts.

The diagnostic services provided by current supervisor relays are thus still ineffective to reduce a possible uncertainty about the actual operating conditions of the coil actuators in a satisfactory way. Obviously, this circumstance may adversely affect the reliability in operation of the electrical systems, in which these devices are installed and used.

In the state of the art, it is therefore quite felt the need for innovative technical solutions capable of mitigating or overcoming the technical issues described above.

The present invention intends to respond to this need by providing a supervisor unit for low and medium voltage applications according to the following claim 1 and related dependent claims. In a general definition, the supervisor unit of the invention is configured to control a coil actuator operatively coupled to or included in a low or medium voltage switching apparatus. The coil actuator comprises a coil electromagnet having a single coil winding and a movable member operatively coupled to suitable mechanical parts (e.g., a kinematic chain) of the switching apparatus.

The coil actuator further comprises a power circuit configured to drive the coil electromagnet upon receiving an input voltage to make the coil actuator carry out a launch and hold manoeuvre.

The coil actuator additionally comprises a controller configured to drive a switch circuit of the power circuit with a driving voltage in order to carry out a PWM control of an input current circulating through the abovementioned power circuit when this latter received an input voltage in such a way that the coil electromagnet is fed with an excitation current.

According to the invention, the supervisor unit is in communication with the controller of the coil actuator and is configured to receive first detection data indicative of a behaviour of electrical quantities of the coil actuator from the controller of the coil actuator.

These electrical quantities advantageously include at least the input voltage received by the power circuit, the excitation current feeding the coil electromagnet and the driving voltage provided by the controller of the coil actuator to drive the switch circuit of the power circuit. According to the invention, the supervisor unit is configured to carry out a diagnostic procedure including the following steps:

- based on the first detection data received from the controller of the coil actuator, calculating one or more timing parameters and quantitative parameters describing the behaviour of electrical quantities of said coil actuator during a launch and hold manoeuvre of said coil actuator;
- based on the calculated timing parameters and quantitative parameters, calculating one or more diagnostic parameters indicative of the operating conditions of one or more components of the coil actuator;
- comparing each diagnostic parameter with corresponding predefined threshold values;
- generating diagnostic information related to the operating conditions of the coil actuator based on a result of said comparison.

According to an aspect of the invention, the supervisor unit is configured to send feedback information related to the operating conditions of the coil actuator to the controller of the coil actuator. Said feedback information is conveniently generated based on the diagnostic information provided through said diagnostic procedure.

Advantageously, the controller of the coil actuator is configured to adjust one or more control parameters in response to the receiving the aforesaid feedback information from the supervisor unit.

According to an aspect of the invention, the supervisor unit is in communication with a control unit operatively coupled with or in said switching apparatus.

The supervisor unit is configured to receive second detection data indicative of the operating conditions of the switching apparatus from the control unit of said switching apparatus. Advantageously, the supervisor unit is configured to carry out an additional diagnostic procedure including the following steps:

- based on the first detection data received from the controller of the coil actuator, calculating a command instant, at which the power circuit of the coil actuator receives an input voltage to carry out a launch and hold manoeuvre;
- based on the second detection data received from the control unit of the switching apparatus, calculating a switch instant, at which the switching apparatus changes an operating condition upon carrying out an opening or closing manoeuvre following a launch and hold manoeuvre of the coil actuator;
- calculating an additional diagnostic parameter indicative of the operation time of the assembly formed by the coil actuator and the switching apparatus based on the calculated timing parameters and quantitative parameters;
- comparing the calculated additional diagnostic parameter with corresponding predefined threshold values;
- generating additional diagnostic information related to the operating conditions of the coil actuator and the switching apparatus based on a result of said comparison.

In a further aspect, the present invention relates to a low or medium voltage electrical system according to claim 10.

Further, characteristics and advantages of the present invention will emerge from the description of preferred, but not exclusive, embodiments of the coil actuator, according to the invention, non-limiting examples of which are provided in the attached drawings, wherein:

- Figure 1 is a schematic view of an electrical system including the supervisor unit of the invention and a coil actuator operatively coupled to or included in a switching apparatus;
- Figure 2 is a schematic view of a coil actuator controlled by the supervisor unit according to the invention;
- Figures 3-6 schematically show some diagnostic procedures carried out by the supervisor unit according to the invention;

With reference to the cited figures, the present invention relates to a supervisor unit 20 for low and medium voltage applications.

For the purposes of the present application, the term "low voltage" is referred to operating voltages lower than 2 kV AC and 2,5 kV DC whereas the term "medium voltage" is referred to higher operating voltages up to some tens of kV, e.g., 72 kV AC and 100 kV DC.

In general, the supervisor unit 20 is configured to control the operation of one or more coil actuators, each operatively coupled to or included in a corresponding switching apparatus 10.

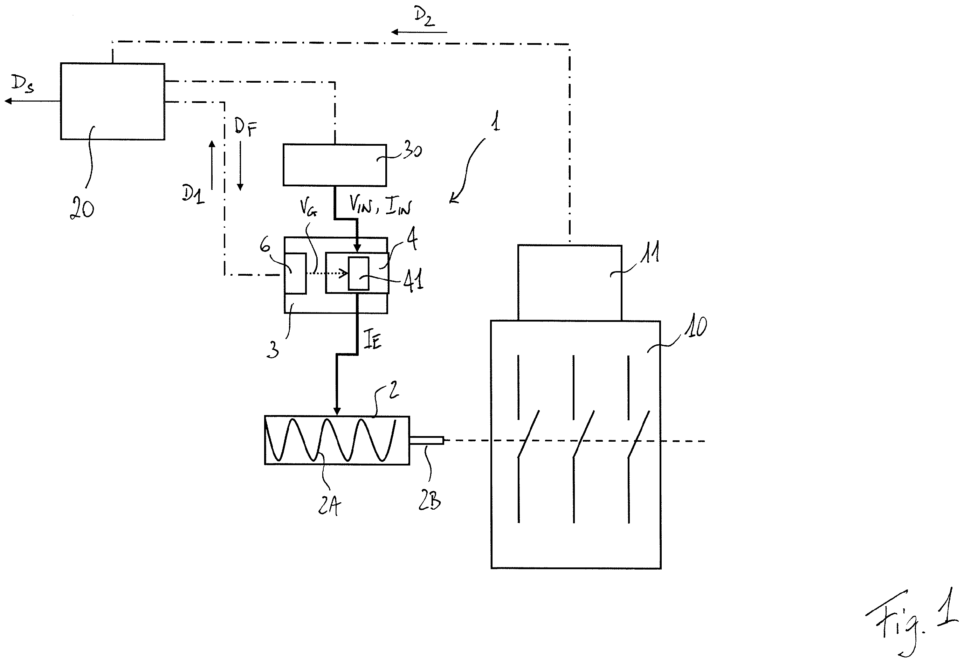

Figure 1 shows an electrical system 100 including a switching apparatus 10, a coil actuator 1 operatively coupled to or included in the switching apparatus and a supervisor unit 20 controlling the operation of the coil actuator.

More generally, an electrical system 100 (e.g., an electrical switchboard, a switchgear, or an electric grid) can include one or more switching apparatuses 10, one or more coil actuators 1, each operatively coupled to or included in a corresponding switching apparatus, and one or more supervisor units 20, according to the invention, each controlling the operation of one or more coil actuators.

Preferably, the electrical system 100 comprises a supervisor unit 20 for each switching apparatus 10.

In principle, the supervisor unit 20 can be formed by any Intelligent Electronic Device (IED) suitably configured to carry out suitable control functionalities, monitoring functionalities, diagnostic functionalities, communication functionalities, according to the needs. As an example, the supervisor unit 20 can be a supervisor relay.

Conveniently, the supervisor unit 20 comprises computerized means (which can include suitable digital processing resources, e.g., one or more microprocessors or digital signal processors) adapted to store and execute software instructions to carry out the foreseen functionalities, such as the innovative diagnostic functionalities described below.

Referring to figure 1, the switching apparatus 10 can be a low or medium voltage circuit breaker, disconnector, contactor, or another electrical apparatus of similar type.

Preferably, the switching apparatus 10 includes or is operatively coupled to a control unit 11.

Also, the control unit 11 can be formed by an Intelligent Electronic Device. As an example, the supervisor unit 20 can be a protection relay or controller. Conveniently, the control unit 11 comprises computerized unit means (which can include suitable digital processing resources, e.g., one or more microprocessors or digital signal processors) adapted to store and execute software instructions to carry out the foreseen functionalities.

Preferably, the supervisor unit 20 and the control unit 11 can mutually communicate in a wired or wireless mode in accordance to communication protocols normally used in this kind of applications. Conveniently, both the devices 20, 11 comprise suitable communication ports (not shown) to communicate one with another.

According to possible embodiments of the invention, the supervisor unit 20 and the control unit 11 can be integrated in a single computerised unit. In this case, they can form distinct computerized modules of a same Intelligent Electronic Device.

In general, the switching apparatus 10 and the control unit 11 can be realized according to solutions of known type and they will be hereinafter described only for the aspects relevant to the invention, for the sake of brevity.

Figures 1-2 show a coil actuator 1 controlled by the supervisor unit 20 of the invention.

The coil actuator 1 comprises a coil electromagnet 2 provided with a single coil winding 2A and a movable member 2B.

The movable member 2B can be reversibly moved between a rest position and an actuated launch position upon the application of an actuation force.

The movable member 2B is moved from the rest position to the actuated position and it is maintained in said actuated position (launch and hold manoeuvre) by an actuation force magnetically generated by feeding the coil electromagnet 2 with an excitation current $I_E$. Once the excitation current $I_E$ is interrupted or sufficiently reduced, the movable member 2B is moved from the actuated position to the rest position through suitable mechanical means (not shown) of the coil electromagnet 2, e.g., a spring suitably charged during the launch and hold manoeuvre.

Preferably, the coil actuator 1 is intended to be operatively coupled to a kinematic mechanism of the switching apparatus 10 in such a way that the movable member 2B of the coil actuator can lock or release mechanical parts of the switching apparatus 10 while carrying out a launch and hold manoeuvre. As an example, when the coil actuator is installed in a circuit breaker, the movable member 2B can be operatively coupled to the primary command chain mechanically driving the movable contacts of said circuit breaker.

According to the invention, the coil actuator 1 comprises a power and control unit 3 configured to drive the coil electromagnet 2 to carry out a launch and hold manoeuvre.

The power and control unit 3 comprises a power circuit 4 (figures 1-2) adapted to receive an input voltage $V_{IN}$ when a launch and hold manoeuvre must be carried out.

Preferably, the input voltage $V_{IN}$ has a DC waveform, for instance a rectified full-wave sinusoidal waveform having a given operating frequency (e.g., 50 Hz). However, in principle, the input voltage $V_{IN}$ can have different waveforms, such as a rectified half-wave sinusoidal waveform, a pulsed waveform, or a continuous waveform.

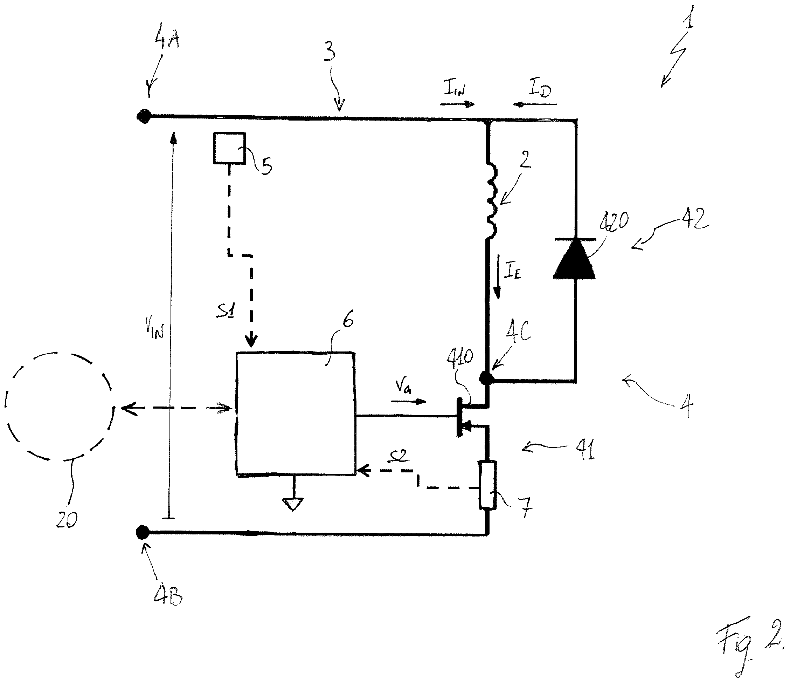

Referring to figure 2, the power circuit 4 comprises a first input terminal 4A and a second input terminal 4B, at which it receives the input voltage $V_{IN}$ and, possibly, an input current $I_{IN}$.

The power circuit 4 is operatively coupled with the coil electromagnet 2 to energize this latter upon receiving the input voltage $V_{IN}$. In this way, when the power circuit 4 is fed with the input voltage $V_{IN}$, the coil electromagnet 2 can receive a suitable excitation current $I_E$ to carry out the desired manoeuvre.

The power circuit 4 comprises a switch circuit 41 and a discharge circuit 42 operatively coupled to the coil electromagnet 2.

The discharge circuit 42 is electrically connected with the first input terminal 4A and an intermediate electric node 4C in such a way to be electrically connected in parallel with the electromagnet 2.

The discharge circuit 42 allows the equivalent inductance formed by the electromagnet 2 to discharge when the power circuit 4 is not fed by an input current $I_{IN}$.

Preferably, the discharge circuit 42 comprises a free-wheeling diode 420 (which can be of conventional type) having its anode and cathode electrically connected respectively with the electric node 4C and the first input terminal 4A.

The switch circuit 41 is electrically connected in series with the parallel group formed by the discharge circuit 42 and the coil electromagnet 2 between the first and second input terminals 4A, 4B. More precisely, the switch circuit 41 is electrically connected between the intermediate electric node 4C and the second input terminal 4B.

The switch circuit 41 is adapted to allow or prevent the input current $I_{IN}$ to circulate through the power circuit 4 between the input terminals 4A and 4B, when the input voltage $V_{IN}$ is applied at these terminals to carry out a launch or hold manoeuvre.

The switch circuit 41 comprises at least a power switch 410 that can be of conventional type, for example a power MOSFET or BJT.

The power switch 410 is conveniently adapted to switch between a conduction state and an interdiction state with a switching frequency very higher than the operating frequency of the electric quantities characterizing the power circuit 4. As an example, the switching frequency of the power switch 410 can be of 10 kHz whereas the input voltage $V_{IN}$ can vary with an operating frequency of some tens of Hz.

When the power switch 410 is in a conduction state, the input current $I_{IN}$ is allowed to circulate through the power circuit 4 and the coil electromagnet 2 through said power switch and the input terminals 4A, 4B. In this case, the equivalent inductance of the coil electromagnet 2 is charged by an excitation current $I_E$. Additionally, the free-wheeling diode 420 is in an interdiction state and no currents will circulate through it (with the exception of small leakage currents).

When the power switch 410 is in an interdiction state, the input current $I_{IN}$ is interrupted. In this case, the free-wheeling diode 420 is in a conduction state and a discharge current $I_D$ circulates through the discharge circuit 42, thereby causing the discharge of the equivalent inductance formed by the electromagnet 2, which is no more fed by an excitation current.

Preferably, the power and control unit 3 comprises first sensing means 5 (e.g., a resistive divider) adapted to provide first detection signals S 1 indicative of the behavior of the input voltage $V_{IN}$ received by the power circuit 4.

Preferably, the power and control unit 3 comprises second sensing means 7 (e.g., a resistive shunt) adapted to provide second detection signals S2 indicative of the behavior of the input current passing $I_{IN}$ through the power circuit 4.

The power and control unit 3 comprises a controller 6 (figure 1-2).

The controller 6 can include one or more computerized units (e.g., microprocessors) configured to execute software instructions to carry out the desired functionalities.

The controller 6 is configured to drive the switch circuit 41 (more precisely the power switch 410) by providing a driving voltage $V_G$ (e.g., of the pulsed type).

Preferably, the controller 6 is operatively coupled to the first sensing means 5 and to the second sensing means 7 in order to receive and process the first and second detection signals S 1, S2 to control the operation of the power switch 410.

The controller 6 is configured to carry out a PWM control the input current $I_{IN}$ circulating through the power circuit 4 when this latter receives an input voltage $V_{IN}$.

The controller 6 carries out the above-mentioned PWM control of the input current $I_{IN}$ in order to obtain a selected operating level for the excitation current $I_E$ feeding the electromagnet 2. Such an operating level can be, for example, a predetermined peak level during a current rising stage of the launch and hold manoeuvre or a predetermined average level during a holding stage of the launch and hold manoeuvre.

The PWM control algorithms carried out by the controller 6 to control the input current $I_{IN}$ can be of known type and they will be not described hereinafter described in further details, for the sake of brevity.

According to the invention, the supervisor unit 20 and the controller 6 can mutually communicate in a wired or wireless mode in accordance to communication protocols normally used in this kind of applications. As an example, the supervisor unit 20 and the controller 6 can communicate through a RS485 communication line. Conveniently, both the devices comprise suitable communication ports (e.g., of the serial type) to communicate one to another. Preferably, the coil actuator 1 comprises or is operatively coupled with a power supply unit 30. The power supply unit 30 is configured to feed the power and control unit 3 (figure 1). In particular, the power supply unit 30 is adapted to provide the input voltage $V_{IN}$ (and possibly the input current $I_{IN}$) received by the power circuit 4 to operate the coil electromagnet 2. Preferably, the power supply unit 30 comprises power supply circuits (not shown) adapted to receive electric power from a power supply source (e.g., an electric line), filtering circuits (not shown) to cut high frequency current components or other electrical disturbances and rectifier circuits to convert a feeding voltage (e.g., a sinusoidal voltage) into a suitable input voltage $V_{IN}$ to be provided to the power circuit 4 of the power and control unit 3.

Preferably, the power supply unit 30 comprises a local controller (not shown), which can include one or more computerized units (e.g., microprocessors) configured to execute software instructions to carry out the desired functionalities.

Preferably, the supervisor unit 20 and the local controller of the power supply unit 30 can mutually communicate in a wired or wireless mode in accordance to communication protocols normally used in this kind of applications. Conveniently, both these devices comprise suitable communication ports (not shown) to communicate one to another.

Preferably, the supervisor unit 20 is configured to control the power supply unit 30 to operate the coil actuator (e.g., particularly to command a launch or hold manoeuvre) or to carry out supervision tests on the coil electromagnet. To this aim, the supervisor unit 20 can exchange suitable control signals or data signals with the controller of the power supply unit 30. According to possible embodiments of the invention, the controller 6 of the coil actuator and the power supply unit 30 can be integrated in a single electronic device. In this case, they can form distinct modules of a same Intelligent Electronic Device.

In general, the power supply unit 30 can be realized according to solutions of known type and it will be hereinafter described only for the aspects relevant to the invention, for the sake of brevity.

As mentioned above, the supervisor unit 20 and the controller 6 of the coil actuator can mutually interact by communicating through a suitable communication channel (e.g., a RS485 communication line).

The supervisor unit 20 and the controller 6 can therefore exchange suitable control signals and data signals directed to command and control the execution of a launch or hold manoeuvre by the coil actuator.

Preferably, the supervisor unit 20 and the controller 6 of the coil actuator are configured to exchange periodically suitable synchronization signals (not shown).

In this way, the supervisor unit 20 and the controller 6 can establish a common timing basis, which is quite useful for calculating suitable timing parameters as better described in the following.

According to the invention, the supervisor unit 20 is configured to receive first detection data $D_1$ from the controller 6.

The first detection data $D_1$ are indicative of specific electrical quantities related to the operation of the coil actuator when this latter carries out a launch manoeuvre or a hold manoeuvre. These electrical quantities advantageously include at least the following electrical quantities:

- the input voltage $V_{IN}$ received by the power circuit 4;
- the excitation current $I_E$ feeding the electromagnet 2 upon the receipt of the input voltage $V_{IN}$;
- the driving voltage $V_G$ provided by the controller 6 to drive the switch circuit 41 of the power circuit.

The controller 6 can advantageously collect data related to the behaviour of the input voltage $V_{IN}$ and of the excitation current $I_E$ based on the first and second sensing signals S1, S2 sent by the first and second sensing means 5, 7 during the operation of the coil actuator.

As to the driving voltage $V_G$, this electrical quantity is directly generated by the controller 6 to drive the switch circuit 41.

In principle, however, the first detection data D1 can be indicative of additional electrical quantities or physical quantities (e.g, operating temperature) related to the operation of the coil actuator.

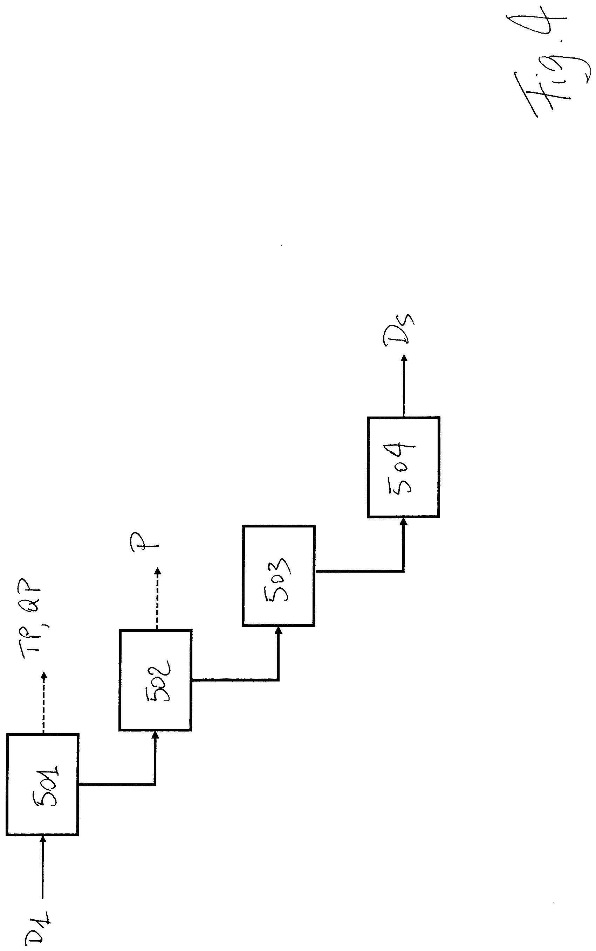

According to the invention, the supervisor unit 20 is configured to carry out a diagnostic procedure 500 directed to provide diagnostic information related to the operating conditions of the coil actuator 1 based on the first detection data $D_1$ received from this latter (figure 4).

The diagnostic procedure 500 comprises a step 501 of calculating one or more timing parameters TP and quantitative parameters QP describing the behaviour of the above-mentioned electrical quantities (in particular the excitation current $I_E$ and the driving voltage $V_G$) during a launch and hold manoeuvre of said coil actuator.

The timing parameters TP can include specific instants or time intervals characterizing the behaviour of the said electrical quantities while the quantitative parameters QP can include specific values taken by said electrical quantities.

The diagnostic procedure 500 comprises a step 503 of calculating one or more diagnostic parameters P indicative of the operating conditions of one or more components of the coil actuator based on the above timing parameters TP and said quantitative parameters QP.

The diagnostic parameters P includes electrical values or timing values, which characterize different stages of the launch and hold manoeuvre and which can be used as pointers of the operating conditions of specific components of the coil actuator.

The diagnostic procedure 500 comprises a step 503 of comparing the calculated diagnostic parameters P with corresponding predefined threshold values.

These threshold values are suitably selected (e.g., in view of previously collected experimental data) to determine whether specific components of the coil actuators are subject to a failure or degradation phenomena, or are correctly operating.

The diagnostic procedure 500 finally comprises a step 504 of generating diagnostic information $D_S$ related to the operating conditions of the coil actuator based on the result of the above-mentioned comparison process carried out for the calculated diagnostic parameters P.

The diagnostic information $D_S$ can include alarm signals, measurement data, reporting data, and the like related to the operating conditions of one or more components of the coil actuator. Preferably, the supervisor unit 20 can transmit the generated diagnostic information $D_S$ remotely (for instance to a centralized control platform, a computerised device, a mobile device, or the like) and/or make it available on a suitable interface that can be accessed by the user. Preferably, the supervisor unit 20 is configured to select or generate feedback information $D_F$ based on the generated diagnostic information $D_S$ and transmit such a feedback information to the controller 6 of the coil actuator.

As an example, the feedback information $D_F$ can include measurement data related to possible operational drifts of some components of the coil actuator.

Preferably, the controller 6 is configured to adjust one or more control parameters in response to receiving the feedback information $D_F$ from the supervisor unit 20.

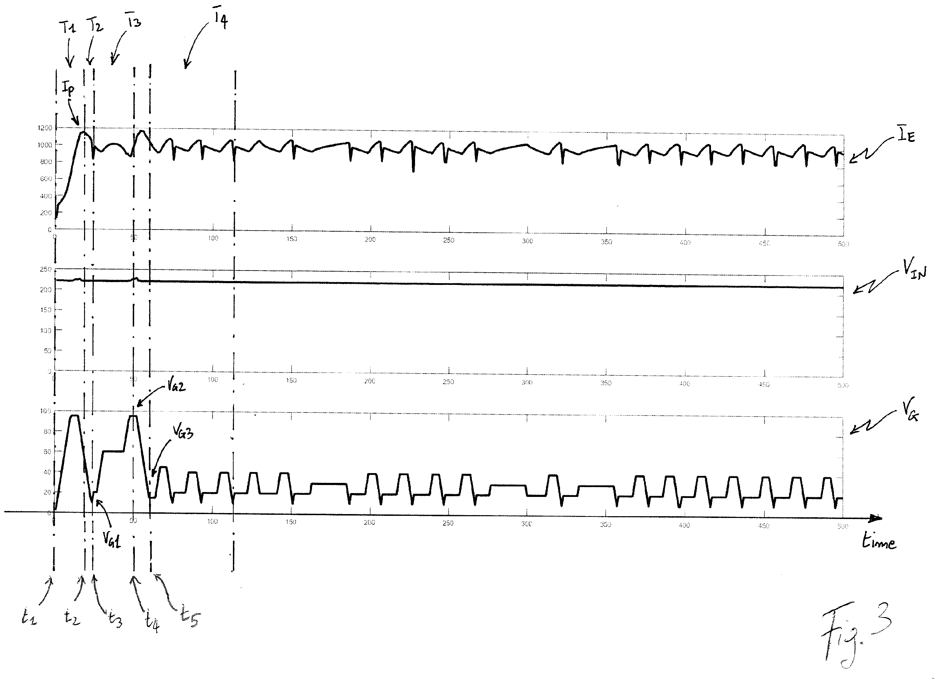

Conveniently, the controller 6 can adjust control parameters used to control the switch circuit 41. As an example, the controller 6 can adjust the instant (instant $t_1$ of figure 3), at which an excitation current $I_E$ starts feeding the coil electromagnet 2 upon the receipt of an input voltage $V_{IN}$ by the power circuit 4.

The controller 6 can thus adapt the operation of the coil actuator to possible electrical and mechanical drifts of some components of said coil actuator in such a way to compensate these degradation phenomena.

As an example, if the movable member 2B of the coil electromagnet 2 is affected by friction phenomena, the controller 6 can speed up the operation of the coil actuator (the instant $t_1$ is anticipated - Figure 3) to compensate possible undesired time delays introduced by the movable member.

As a further example, if the movable member 2B of the coil electromagnet 2 is affected by wear phenomena, the controller 6 can slow down the operation of the coil actuator (the instant $t_1$ is delayed - Figure 3) to compensate possible undesired increases of the speed of the movable member.

These adaptive capabilities of the operation of the coil actuator based on the diagnostic services provided by the supervisor unit 20 allow remarkably improving the reliability in operation of the switching apparatus and, more generally, of the electrical system where the switching apparatus is installed.

As a matter of fact, a drifted behaviour of some components of coil actuator can remarkably influence the operation of the switching apparatus, which in turn can have a greatly impact on the operation of the electrical system where the switching apparatus is installed.

For instance, a coil actuator can delay its intervention because the movable member 2B of the coil electromagnet 2 is affected by friction phenomena. Such a delay may, in turn, cause a delay of an opening or closing manoeuvre carried out by the switching apparatus, which may greatly influence the management of an electric grid, in which the switching apparatus is installed. As it is capable of self-compensating possible operational drifts of some internal components based on the diagnostic services provided by the supervisor unit 20, the coil actuator 1 can ensure performances substantially constant in time, which allows mitigating the impact of these operational drifts on the operation of the switching apparatus.

Before describing in more details some possible implementations of the diagnostic procedure 500, a launch and hold manoeuvre of the coil actuator is briefly described with reference to figure 3, where it is shown the behaviour of the input voltage $V_{IN}$ received by the power circuit 4, the excitation current $I_E$ feeding the electromagnet 2 upon the receipt of the input voltage $V_{IN}$ by the power circuit 4 and the driving voltage $V_G$ provided by the controller 6 to drive the switch circuit 41 of the power circuit 4 during a launch and hold manoeuvre of the coil actuator (first detection data $D_1$).

The coil actuator 1 is supposed to be in an initial rest condition, ready for operation.

The movable member 2B of the coil electromagnet 2 is in a rest position.

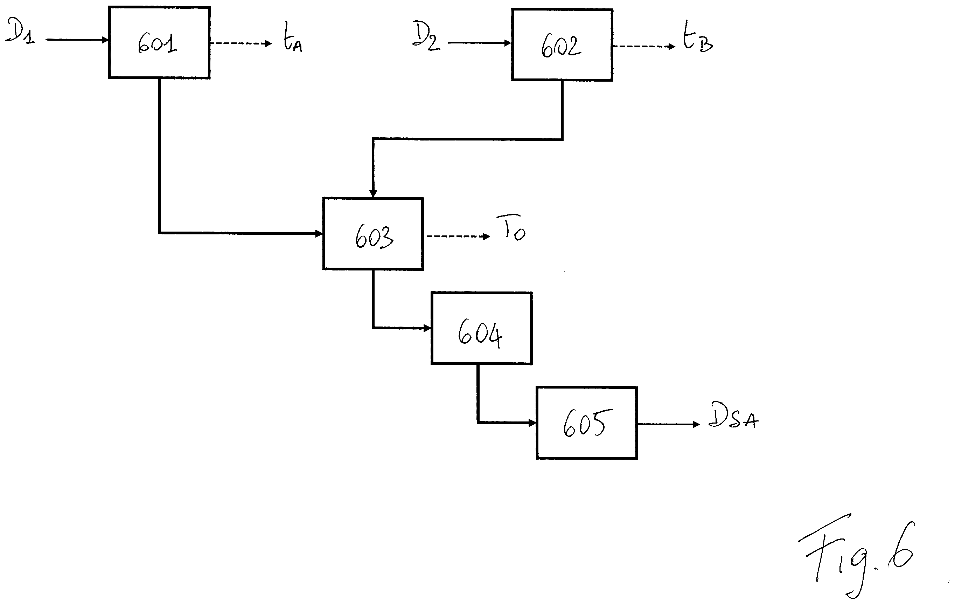

At the command instant $t_A$ (figure 6), the power circuit 4 receives an input voltage $V_{IN}$. Following the command instant $t_A$, the controller 6 introduces a time delay before commanding the launch and hold manoeuvre.

During such a time delay, the controller 6 drives the switch circuit 41 in such a way to prevent the circulation of an input current $I_{IN}$ through the power circuit 4.

The controller 6 thus provides a null driving voltage $V_G$ (duty cycle value $\delta = 0$) to the switch circuit 41. The coil electromagnet 2 is not fed by any excitation current $I_E$ and the movable member 2B of the coil electromagnet remains in its rest position.

As mentioned above, the controller 6 can adjust the above-mentioned time delay to speed up or delay the operation of the coil actuator.

At a first instant $t_1$, the controller 6 commands the execution of the launch and hold manoeuvre of the coil actuator.

The controller 6 increases the driving voltage $V_G$ (by increasing the duty cycle $\delta$) up to a relative maximum value and the excitation current $I_E$ feeding the coil electromagnet 2 starts rising until reaching a first relative maximum value Ip at a second instant $t_2$.

The time interval $T_1$ between the subsequent instants $t_1$ and $t_2$ represents a current rising stage of the launch and hold manoeuvre, during which the coil electromagnet 2 is not fully energized yet. The movable member 2B of the coil electromagnet therefore remains in a rest position during this stage of the launch and hold manoeuvre.

Following the instant $t_2$, the excitation current $I_E$ remains substantially constant until an instant $t_3$, at which the movable member 2B of the coil electromagnet starts moving and the excitation current $I_E$ starts increasing again. In order to maintain, the excitation current $I_E$ substantially constant, the controller 6 decreases the driving voltage $V_G$ (by decreasing the duty cycle $\delta$) down to a relative minimum value $V_{G1}$ at the instant $t_3$.

The time interval $T_2$ between the subsequent instants $t_2$ and $t_3$ represents an energization stage of the launch and hold manoeuvre, during which the full energization of the coil electromagnet 2 is achieved. The movable member 2B of the coil electromagnet still remains in a rest position during this energization stage of the launch and hold manoeuvre.

Following the instant $t_3$, the movable member 2B of the coil electromagnet moves from the rest position to towards an actuated position.

The controller 6 progressively increases the driving voltage $V_G$ up to a new relative maximum value $V_{G2}$ that is maintained until the movable member 2B of the coil electromagnet reaches the actuated position at the instant $t_4$.

The time interval $T_3$ between the subsequent instants $t_3$ and $t_4$ represents an actuation stage of the launch and hold manoeuvre, during which the excitation current $I_E$ may remain approximately constant or decrease as the progressively increasing driving voltage $V_G$ counteracts the back electromagnetic force naturally induced to oppose the movement of the movable member 2B of the coil electromagnet.

Following the instant $t_4$, at which the displacement of the movable member 2B of the coil electromagnet is completed, the controller 6 decreases the driving voltage $V_G$ down to a relative minimum value $V_{G3}$ that is reached at the instant $t_5$.

The time period following the instant $t_5$ represents a holding stage of the launch and hold manoeuvre.

The coil electromagnet 2 is still fed by an excitation current $I_E$. The controller 6 varies in a reciprocating manner the driving voltage $V_G$ to maintain the excitation current $I_E$ at a predetermined holding level.

The movable member 2B of the coil electromagnet is maintained in the actuated position reached at the instant $t_4$ as the coil electromagnet 2 is kept energized.

The holding stage of the launch and hold manoeuvre will continue until the power circuit 4 is fed with an input voltage $V_{IN}$.

When the power circuit is no more fed with an input voltage $V_{IN}$, the launch and hold manoeuvre of the coil actuator is terminated and the movable member 2B of the coil electromagnet 2 returns in the rest opposition.

According to an embodiment of the invention, the diagnostic procedure 500 can be executed to calculate and check a diagnostic parameter L indicative of the magnetic behaviour of the electromagnet 2. Such a diagnostic parameter is conveniently calculated during the current rising stage of the launch and hold manoeuvre, when the coil electromagnet is fed with a highly variable current (figures 3-4).

According to this embodiment of the invention, the diagnostic procedure 500 comprises:

- calculating a first instant $t_1$, at which the excitation current $I_E$ starts rising following the receipt of the input voltage $V_{IN}$ by the power circuit 4;
- calculating a second instant $t_2$, at which the excitation current $I_E$ reaches a relative maximum;
- calculating a peak current value Ip indicative of the relative maximum reached by the excitation current $I_E$ at the second instant $t_2$;
- calculating a time interval $T_1$ between the above-mentioned first instant $t_1$ and second instant $t_2$.

Both the first and second instants instant $t_1$, $t_2$ the peak current value Ip can be calculated based on the first detection data $D_1$ received from the controller 6 of the coil actuator, more particularly on the detection data describing the behaviour of the excitation current $I_E$ and the input voltage $V_{IN}$ (figure 3).

The time interval $T_1$ is indicative of the duration of the current rising stage of the launch and hold manoeuvre and it can be calculated according to the following relation:

$$T_1 = t_2 - t_1$$

wherein $t_1$, $t_2$ are the above-calculated first and second instants.

The diagnostic procedure 500 then comprises the step of calculating an average voltage value $V_E$ applied to the electromagnet 2 during the time interval $T_1$.

The average voltage value $V_E$ can be calculated based on the input voltage $V_{IN}$ and the duty-cycle of the driving voltage $V_G$ during the time interval $T_1$. These quantities can be calculated based on the first detection data $D_1$ received from the controller 6 of the coil actuator, more particularly on the detection data describing the behaviour of input voltage $V_{IN}$ and the driving voltage $V_G$ (figure 3).

The average voltage value $V_E$ can therefore be calculated according to the following relation:

$$V_E = V_{in} * \delta$$

where $\delta$ is the duty-cycle value of the driving voltage $V_G$ and $V_{in}$ is the (approximately constant) value of the input voltage $V_{IN}$ received by the power circuit 4.

It is evidenced how the above-calculated values $t_1$, $t_2$, $\delta$, Ip, $V_{in}$, $V_E$ represent timing parameters and quantitative parameters describing the behaviour of electrical quantities of the coil actuator during the launch and hold manoeuvre (step 501 of the diagnostic procedure).

The diagnostic procedure 500 then provides for calculating a diagnostic parameter L indicative of the equivalent inductance of the coil electromagnet 2 based on the calculated timing parameters $t_1$, $t_2$, $T_1$ and quantitative parameters $\delta$, Ip, $V_{in}$, $V_E$ (step 502 of the diagnostic procedure).

Such a diagnostic parameter L is an equivalent inductance value and it can be calculated according to the following relation:

$$L = (V_E * T_1) / Ip$$

where $T_1$ is the above-calculated time interval, $V_E$ is the above-calculated average voltage value and Ip is the above-calculated peak current value.

The diagnostic procedure 500 then provides for comparing the diagnostic parameter L with predefined first threshold values $L_L$, $L_H$.

The above-mentioned comparison is directed to check whether the first diagnostic parameter L falls within the range of values defined by the threshold values $L_L$, $L_H$. In practice, this step of the diagnostic procedure checks whether the following relation:

$$L_L < L < L_H$$

is satisfied or not.

If the first diagnostic parameter L does not fall within the above-mentioned range of values, the winding coil 2A of the coil electromagnet 2 may be damaged (e.g., some turns may be shortcircuited) and subject to excessive heating phenomena.

The diagnostic procedure 500 provides for generating diagnostic information $D_S$ related to the operating conditions of the coil electromagnet 2 based on the result of the above-described comparison.

According to a further embodiment of the invention, the diagnostic procedure 500 can be executed to calculate and check a further diagnostic parameter $T_2$ indicative of the magnetic behaviour of the electromagnet 2 during the energization stage of the launch and hold manoeuvre (figures 3-4).

According to this embodiment of the invention, the diagnostic procedure 500 comprises:

- calculating a first instant $t_1$, at which the excitation current $I_E$ starts rising following the receipt of the input voltage $V_{IN}$ by the power circuit 4;
- calculating a second instant $t_2$, at which the excitation current $I_E$ reaches a relative maximum;
- calculating a third instant $t_3$, at which the movable member 2B of the coil electromagnet starts moving from a rest position as it is actuated by a magnetic force generated by said coil electromagnet.

The above-mentioned first, second and third instants $t_1$, $t_2$, $t_3$ can be calculated based on the first detection data $D_1$ received from the controller 6 of the coil actuator, more particularly on the detection data describing the behaviour of the excitation current $I_E$ and the driving voltage $V_G$ (figure 3).

Again, it is evidenced how the above-calculated values $t_1$, $t_2$, $t_3$ represent timing parameters describing the behaviour of electrical quantities of the coil actuator during a launch and hold manoeuvre (step 501 of the diagnostic procedure).

The diagnostic procedure 500 then provides for calculating a diagnostic parameter $T_2$ indicative of an energization time of the coil electromagnet 2 based on the calculated timing parameters $t_1$, $t_2$, $t_3$ (step 502 of the diagnostic procedure).

Such a diagnostic parameter is a time interval $T_2$ between the subsequent instants $t_2$, t3 and it can be calculated based on the following relation:

$$T_2 = t_3 - t_2$$

wherein $t_2$, $t_3$ are the above-calculated second and third instants.

The diagnostic procedure 500 then provides for comparing the diagnostic parameter $T_2$ with predefined first threshold values $T_{2L}$, $T_{2H}$.

The above-mentioned comparison is directed to check whether the diagnostic parameter $T_2$ falls within the range of values defined by the threshold values $T_{2L}$, $T_{2H}$. In practice, this step of the diagnostic procedure checks whether the following relation:

$$T_{2L} < T_2 < T_{2H}$$

is satisfied or not.

If the first diagnostic parameter $T_2$ does not fall within the above-mentioned range of values, the winding coil 2A of the coil electromagnet may be damaged (e.g., some turns may be shortcircuited) and subject to excessive heating phenomena.

The diagnostic procedure 500 provides for generating diagnostic information $D_S$ related to the operating conditions of the coil electromagnet 2 based on the result of the above-described comparison.

According to a further embodiment of the invention, the diagnostic procedure 500 can be executed to calculate and check a further diagnostic parameter $T_3$ indicative of the mechanical behaviour of the coil electromagnet 2 during the actuation stage of the launch and hold manoeuvre (figures 3-4).

According to this embodiment of the invention, the diagnostic procedure 500 comprises:

- calculating a first instant $t_1$, at which the excitation current $I_E$ starts rising upon the receipt of the input voltage $V_{IN}$ by the power circuit 4;

- calculating a second instant $t_2$, at which the excitation current $I_E$ reaches a relative maximum;
- calculating a third instant $t_3$, at which the movable member 2B of the coil electromagnet starts moving from the rest position as it is actuated by a magnetic force generated by said coil electromagnet;
- calculating a fourth instant $t_4$, at which the movable member 2B of the coil electromagnet stops moving as it has reached the actuated position.

The above-mentioned first, second and third instants $t_1$, $t_2$, $t_3$, $t_4$ can be calculated based on the first detection data $D_1$ received from the controller 6 of the coil actuator, more particularly on the detection data describing the behaviour of the excitation current $I_E$ and the driving voltage $V_G$ (figure 3).

Again, it is evidenced how the above-calculated values $t_1$, $t_2$, $t_3$, $t_4$ represent timing parameters describing the behaviour of electrical quantities of the coil actuator during the launch and hold manoeuvre (step 501 of the diagnostic procedure).

The diagnostic procedure 500 then provides for calculating a further diagnostic parameter $T_3$ indicative of an actuation time of the coil electromagnet 2 based on the calculated timing parameters $t_1$, $t_2$, $t_3$, $t_4$ (step 502 of the diagnostic procedure).

Such a diagnostic parameter is the time interval $T_3$ between the subsequent instants $t_3$, $t_4$ and it can be calculated based on the following relation:

$$T_3 = t_4 - t_3$$

wherein $t_3$, $t_4$ are the above-calculated third and fourth instants.

The diagnostic procedure 500 then provides for comparing the third diagnostic parameter $T_3$ with predefined corresponding third threshold values $T_{3L}$, $T_{3H}$.

The above-mentioned comparison is directed to check whether the third diagnostic parameter $T_3$ falls within the range of values defined by the threshold values $T_{3L}$, $T_{3H}$. In practice, this step of the diagnostic procedure checks whether the following relation:

$$T_{3L} < T_3 < T_{3H}$$

is satisfied or not.

If the first diagnostic parameter $T_3$ does not fall within the above-mentioned range of values, the movable member 2B of the coil electromagnet 2 may be subject to excessive wear phenomena ($T_3 < T_{3L}$) or friction phenomena ($T_3 > T_{3H}$).

The diagnostic procedure 500 provides for generating diagnostic information $D_S$ related to the operating conditions of the coil electromagnet 2 based on the result of the above-described comparison.

According to a further embodiment of the invention, the diagnostic procedure 500 allows calculating a further diagnostic parameter R indicative of the electrical (resistive) behaviour of the electromagnet 2. Such a diagnostic parameter is conveniently calculated during the holding stage of the launch and hold manoeuvre of the coil actuator, where the coil electromagnet is fed with an approximately constant current (figures 3-4).

According to this embodiment of the invention, the diagnostic procedure 500 comprises:

- calculating a first instant $t_1$, at which the excitation current $I_E$ starts rising upon the receipt of the input voltage $V_{IN}$ by the power circuit 4;
- calculating a second instant $t_2$, at which the excitation current $I_E$ reaches a relative maximum;
- calculating a third instant $t_3$, at which the movable member 2B of the coil electromagnet starts moving from a rest position as it is actuated by a magnetic force generated by said coil electromagnet;
- calculating a fourth instant $t_4$, at which the movable member 2B of the coil electromagnet stops moving as it has reached an actuated position;
- calculating a fifth instant $t_5$, at which the holding stage of the launch and hold manoeuvre of the coil actuator begins.

The above-mentioned first, second and third instants $t_1$, $t_2$, $t_3$, $t_4$, $t_5$ can be calculated based on the first detection data $D_1$ received from the controller 6 of the coil actuator, more particularly on the detection data describing the behaviour of the excitation current $I_E$ and the driving voltage $V_G$ (figure 3).

The diagnostic procedure 500 then comprises the step of calculating an average voltage value $V_E$ applied to the electromagnet 2 during a predefined time interval $T_4$ starting from the fifth instant $t_5$.

The average voltage value $V_E$ can be calculated based on the input voltage $V_{IN}$ and the duty-cycle of the driving voltage $V_G$ during the time interval $T_4$. These quantities can be calculated based on the first detection data $D_1$ received from the controller 6 of the coil actuator, more particularly on the detection data describing the behaviour of input voltage $V_{IN}$ and the driving voltage $V_G$ (figure 3).

The average voltage value $V_E$ can therefore be calculated based according to the following relation:

$$V_E = V_{in} * \delta$$

where $\delta$ is the duty-cycle value of the driving voltage $V_G$ and $V_{in}$ is the (approximately constant) value of the input voltage $V_{IN}$ received by the power circuit 4.

It is yet evidenced how the above-calculated values $t_1$, $t_2$, $t_3$, $t_4$, $t_5$ $\delta$, $V_{in}$, $V_E$ are timing parameters and quantitative parameters describing the behaviour of electrical quantities of the coil actuator (step 501 of the diagnostic procedure).

The diagnostic procedure 500 then comprises the step of calculating an average current value $I_{EH}$ of the excitation current $I_E$ feeding to the coil electromagnet 2 during the time interval $T_4$. The average current value $I_{EH}$ can be calculated based on the first detection data $D_1$ received from the controller 6 of the coil actuator, more particularly on the detection data describing the behaviour of excitation current $I_E$ (figure 3).

The diagnostic procedure 500 then provides for calculating a diagnostic parameter R indicative equivalent resistance value of the coil electromagnet 2 based on the calculated timing parameters $T_4$ and quantitative parameters $I_{EH}$, $V_E$ (step 502 of the diagnostic procedure). This diagnostic parameter is an equivalent resistance value and it can be calculated according to the following relation:

$$R = V_E / I_{EH}$$

where $V_E$ is the above-calculated average voltage value and $I_{EH}$ is the above-calculated average current value during the time interval $T_4$ (holding stage of the launch and hold manoeuvre of the coil actuator).

The diagnostic procedure 500 then provides for comparing the diagnostic parameter R with corresponding predefined threshold values $R_L$, $R_H$.

The above-mentioned comparison is directed to check whether the diagnostic parameter R falls within the range of values defined by the threshold values $R_L$, $R_H$. In practice, this step of the diagnostic procedure checks whether the following relation:

$$R_L < R < R_H$$

is satisfied or not.

If the first diagnostic parameter R does not fall within the above-mentioned range of values, the winding coil 2A of the coil electromagnet 2 may be damaged (e.g., some turns may be shortcircuited) and subject to excessive heating phenomena. It is also possible that the electronics of the power circuit 4 is subject to aging phenomena.

As the skilled person can certainly understand, the diagnostic procedure 500 can be executed to calculate additional diagnostic parameters indicative of the operating conditions of one or more components of the coil actuator based on the first detection data $D_1$ received from the controller 6. The kind of diagnostic services provided by the supervisor unit can thus be conveniently adjusted according to the needs

As mentioned above, the supervisor unit 20 and the control unit 11 of the switching can mutually interact by communicating through a suitable communication channel.

Preferably, the supervisor unit 20 is configured to receive second detection data $D_2$ from the control unit 11.

The second detection data $D_2$ are indicative of

indicative of the operating conditions of said switching apparatus 10, in particular of a change of condition (from a closed condition to an open condition or vice-versa) of the switching apparatus upon the execution of an opening manoeuvre or a closing manoeuvre triggered by the coil actuator 1.

Preferably, the supervisor unit 20 is directed to carry out an additional diagnostic procedure 600 based on the first detection data $D_1$ received from the controller 6 of the coil actuator and on the second detection data $D_2$ received from the control unit 11 of the switching apparatus 10. The additional diagnostic procedure 600 is directed to provide some additional diagnostic information $D_{SA}$, which may be relevant in relation to the operating conditions of the coil actuator 2 and of the switching apparatus.

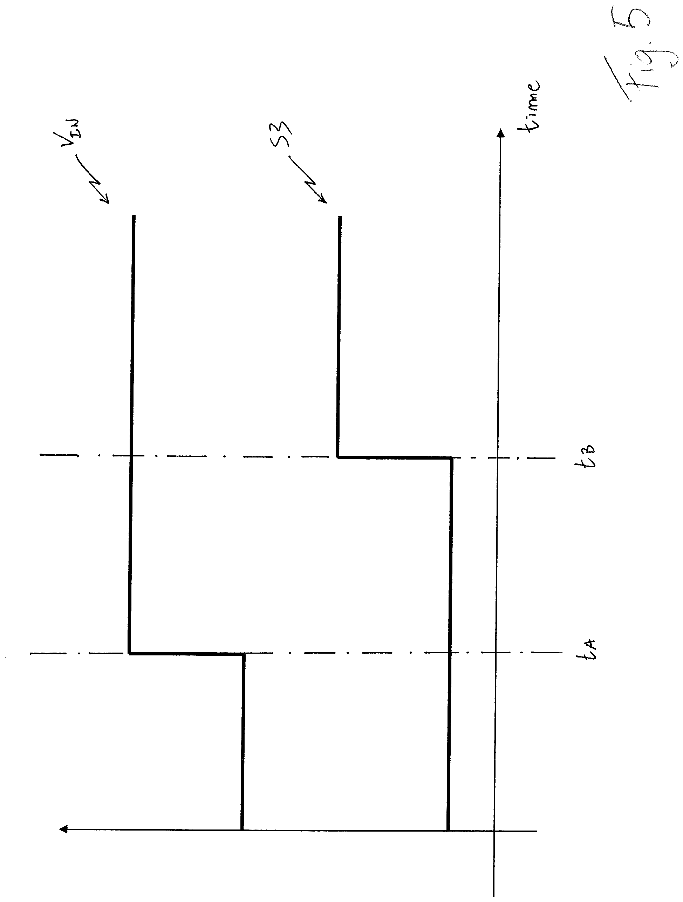

Referring to figures 5-6, the additional diagnostic procedure 600 comprises a step 601 of calculating a command instant $t_A$, at which the power circuit 4 of the coil actuator receives an input voltage $V_{IN}$ to carry out a launch and hold manoeuvre. The command instant $t_A$ is calculated based on the first detection data $D_1$ received from the controller 6 of the coil actuator, more particularly on the detection data describing the behaviour of the input voltage $V_{IN}$.

The additional diagnostic procedure 600 further comprises a step 602 of calculating a switch instant $t_B$, at which the switching apparatus 10 changes an operating condition as a consequence of an opening or closing manoeuvre of said switching actuator. Such an opening or closing manoeuvre is carried out upon a launch and hold manoeuvre executed by the coil actuator. The command instant $t_B$ is calculated based on the first detection data $D_2$.

The additional diagnostic procedure 600 then comprises a step 603 of calculating an additional diagnostic parameter $T_O$ indicative of the operation time of the assembly formed by the coil actuator 1 and the switching apparatus 10.

The additional diagnostic parameter $T_O$ is a time interval, which can be calculated based on the timing parameters $t_A$, $t_B$ calculated at the preceding steps of the additional diagnostic procedure, according to the following relation:

$$T_O = t_B - t_A$$

The additional diagnostic procedure 600 then comprises a step 603 of comparing the additional diagnostic parameter $T_O$ with a corresponding predefined minimum threshold value $T_{OL}$ and maximum threshold value $T_{OH}$.

The additional diagnostic procedure 600 then comprises a step 604 of generating additional diagnostic information $D_{SA}$ related to the operating conditions of the coil actuator and the switching apparatus based on a result of the comparison.

The additional diagnostic information $D_{SA}$ can include alarm signals, measurement data, reporting data, and the like related to the operating conditions of one or more components of the coil actuator.

The diagnostic procedure 600 is basically focused on the analysis of a timing parameter $T_O$ indicative of the operation time of the assembly formed by the coil actuator 2 and the switching apparatus 10.

If such a timing parameter does not fall within the range of values defined by the threshold values $T_{OL}$, $T_{OH}$, the additional diagnostic information $D_{SA}$ will signal that there might be a problem either at level of the coil actuator 1 or at level of the kinematic chain of the switching apparatus, which is operatively coupled to the coil actuator.

The situation can be clarified in view of the results of the above-described diagnostic procedure 500. If the diagnostic procedure 500 highlights an incorrect behaviour of one or more components of the coil actuator, there is a high probability that the problem resides in the coil actuator 1 and not in the switching apparatus 10. On the other hand, if the diagnostic procedure 500 does not evidence an incorrect behaviour of the coil actuator, there is a high probability that the problem resides in the kinematic chain of the switching apparatus 10.

The diagnostic procedure 600 has therefore the advantage of providing additional diagnostic information $D_{SA}$ that can be cross-checked with the diagnostic information $D_S$ provided by diagnostic procedure 500 to properly direct possible maintenance interventions.

The supervisor unit 20, according to the invention, provides relevant advantages.

The supervisor unit 20 can provide advanced diagnostic services based on detection data describing the behaviour of electrical quantities of the coil actuator during a launch and hold manoeuvre.

The supervisor unit 20 can determine whether critical components (the coil winding, the movable member, the power circuit) of the coil actuator are subject to a failure or are affected by possible on-going deterioration phenomena.

Also, the diagnostic services provided by the supervisor unit 20 allow preparing accurate maintenance planes of the monitored coil actuators and of the switching apparatuses, to which said coil actuators are operatively associated.

The supervisor unit 20 can also provide the controller of the coil actuator with suitable feedback information related to possible drifts in operation. The controller of the coil actuator is thus put in conditions to adapt some control parameters in view of the actual operating conditions of the coil actuator in such a way to ensure stable and high-level performances of the coil actuator. This solution provides relevant advantages for the reliability in operation of the electrical systems, in which the coil actuator is installed and used.

The supervisor unit 20 can provide the above-mentioned advanced diagnostic in a relatively easy manner without the need of installing powerful calculation resources.

The supervisor unit 20 can be manufactured at industrial level in a relatively simple manner at competitive costs with respect to currently available devices of the same type.

## Claims

1. A supervisor unit (20) for low or medium voltage applications,

   wherein said supervisor unit is configured to control a coil actuator (1) operatively coupled to or included in a switching apparatus (10), wherein said coil actuator comprises a coil electromagnet (2) having a single coil winding (2A) and a movable member (2B) operatively coupled to mechanical parts (12) of said switching apparatus, wherein said coil actuator further comprises a power circuit (4) configured to drive said coil electromagnet (2) upon receiving an input voltage ($V_{IN}$) to make said coil actuator to carry out a launch and manoeuvre, wherein said coil actuator further comprises a controller (6) configured to drive a switch circuit (41) of said power circuit (4) with a driving voltage ($V_G$) to carry out a PWM control an input current ($I_{IN}$) circulating through said power circuit (4) upon the receipt of said input voltage ($V_{IN}$) by said power circuit in such a way that said coil electromagnet is fed with an excitation current ($I_E$);
   wherein said supervisor unit (20) is in communication with the controller (6) of said coil actuator and is configured to receive first detection data ($D_1$) indicative of a behaviour of electrical quantities ($V_{IN}$, $I_E$, $V_G$) of said coil actuator from the controller (6) of said coil actuator, wherein said electrical quantities include at least the input voltage ($V_{IN}$) received by said power circuit (4), the excitation current ($I_E$) feeding said coil electromagnet (2) and the driving voltage ($V_G$) provided by the controller (6) of said coil actuator to drive the switch circuit (41) of said power circuit;
   **characterised in that** said supervisor unit (20) is configured to carry out a diagnostic procedure (500) including the following steps:

      - based on said first detection data ($D_1$), calculating (501) one or more timing parameters (TP) and quantitative parameters (QP) describing the behaviour of electrical quantities of said coil actuator during a launch and hold manoeuvre of said coil actuator;
- based on said timing parameters and quantitative parameters, calculating (502) one or more diagnostic parameters (P) indicative of the operating conditions of one or more components of said coil actuator;
- comparing (503) each diagnostic parameter (P) with corresponding predefined threshold values;
- generating (504) diagnostic information (Ds) related to the operating conditions of said coil actuator based on a result of said comparison.

2. Supervisor unit, according to claim 1, **characterised in that** said supervisor unit (20) is configured to send feedback information ($D_F$) related to the operating conditions of said coil actuator to the controller (6) of said coil actuator, wherein said feedback information is generated based on said diagnostic information (Ds).

3. Supervisor unit, according to claim 2, **characterised in that** the controller (6) of said coil actuator is configured to adjust one or more control parameters in response to the receiving said feedback information ($D_F$) from said supervisor unit (20).

4. Supervisor unit, according to one of the previous claims, **characterised in that** said diagnostic procedure (500) includes the following steps:

   - calculating a first instant ($t_1$), at which said excitation current ($I_E$) starts rising following the receipt of said input voltage ($V_{IN}$) by said power circuit (4) during a launch and hold manoeuvre of said coil actuator;
   - calculating a second instant (tz), at which said excitation current ($I_E$) reaches a relative maximum;
   - calculating a peak current value (Ip) indicative of said excitation current ($I_E$) at said second instant ($t_2$);
   - calculating an average voltage value ($V_E$) indicative of a voltage applied to said coil electromagnet (2) during a time interval ($T_1$) indicative of a rising time of said excitation current ($I_E$);
   - calculating a diagnostic parameter (L) indicative on an equivalent inductance of said coil electromagnet (2) based on the calculated timing parameters and quantitative parameters;
   - comparing said diagnostic parameter (L) with corresponding threshold values ($L_L$, $L_H$);
   - generating diagnostic information (Ds) related to the operating conditions of said coil electromagnet (2) based on the result of said comparison.

5. Supervisor unit, according to one of the previous claims, **characterised in that** said diagnostic procedure (500) includes the following steps:

- calculating a first instant ($t_1$), at which said excitation current ($I_E$) starts rising following the receipt of said input voltage ($V_{IN}$) by said power circuit (4) during a launch and hold manoeuvre of said coil actuator;
- calculating a second instant (tz), at which said excitation current ($I_E$) reaches a relative maximum;
- calculating a third instant ($t_3$), at which the movable member (2B) of said coil electromagnet starts moving from a rest position during said launch and hold manoeuvre;
- calculating a diagnostic parameter ($T_2$) indicative of an energization time of said coil electromagnet (2) based on the calculated timing parameters ($t_2$, $t_3$);
- comparing said second diagnostic parameter ($T_2$) with corresponding threshold values ($T_{2H}$, $T_{2L}$);
- generating second diagnostic information ($D_{S2}$) related to the operating conditions of said coil electromagnet (2) based on the result of said comparison.

6. Supervisor unit, according to one of the previous claims, **characterised in that** said diagnostic procedure includes the following steps:

- calculating a first instant ($t_1$), at which said excitation current ($I_E$) starts rising following the receipt of said input voltage ($V_{IN}$) by said power circuit (4) during a launch and hold manoeuvre of said coil actuator;
- calculating a second instant ($t_2$), at which said excitation current ($I_E$) reaches a relative maximum;
- calculating a third instant ($t_3$), at which the movable member (2B) of said coil electromagnet starts moving from a rest position during said launch and hold manoeuvre;
- calculating a fourth instant ($t_4$), at which the movable member (2B) of said coil electromagnet reaches an actuated position during said launch and hold manoeuvre;
- calculating a diagnostic parameter ($T_3$) indicative of an actuation time of said coil electromagnet (2) based on the calculated timing parameters and quantitative parameters;
- comparing said third diagnostic parameter ($T_3$) with corresponding threshold values ($T_{3H}$, $T_{3L}$);
- generating diagnostic information related to the operating conditions of said coil electromagnet (2) based on the result of said comparison.

7. Supervisor unit, according to one of the previous claims, **characterised in that** said diagnostic procedure includes the following steps:

- calculating a first instant ($t_1$), at which said excitation current ($I_E$) starts rising following the receipt of said input voltage ($V_{IN}$) by said power circuit (4) during a launch and hold manoeuvre of said coil actuator;
- calculating a second instant ($t_2$), at which said excitation current ($I_E$) reaches a relative maximum;
- calculating a third instant ($t_3$), at which the movable member (2B) of said coil electromagnet starts moving from a rest position during said launch and hold manoeuvre;
- calculating a fourth instant ($t_4$), at which the movable member (2B) of said coil electromagnet reaches an actuated position during said launch and hold manoeuvre;
- calculating a fifth instant ($t_5$), at which a holding stage of said launch and hold manoeuvre begins;
- calculating an average voltage value ($V_E$) applied to said coil electromagnet (2) during a predefined time interval ($T_4$) starting from said fifth instant ($t_5$);
- calculating a diagnostic parameter (R) indicative on an equivalent resistance of said coil electromagnet (2) based on the calculated timing parameters and quantitative parameters;
- comparing said fifth diagnostic parameter (R) with corresponding threshold values ($R_L$, $R_H$);
- generating diagnostic information ($D_S$) related to the operating conditions of said coil electromagnet (2) and said power circuit (4) based on the result of said comparison.

8. Supervisor unit, according to one of the previous claims, **characterised in that** said supervisor unit (20) is in communication with a control unit (11) operatively coupled with or in said switching apparatus,

wherein said supervisor unit is configured to receive second detection data ($D_2$) indicative of the operating conditions of said switching apparatus (10) from said control unit (11).

9. Supervisor unit, according to claim 8, **characterised in that** it is configured to carry out an additional diagnostic procedure (600) including the following steps:

- based on said first detection data ($D_1$), calculating (601) a command instant ($t_A$), at which said power circuit (4) receives an input voltage ($V_{IN}$) to carry out a launch and hold manoeuvre;
- based on said second detection data ($D_2$),

calculating (602) a switch instant ($t_B$), at which said switching apparatus (10) changes an operating condition upon carrying out an opening or closing manoeuvre following a launch and hold manoeuvre of said coil actuator;

- calculating an additional diagnostic parameter ($T_O$) indicative of the operation time of the assembly formed by said coil actuator and said switching apparatus based on the calculated timing parameters and quantitative parameters;
- comparing said additional diagnostic parameter ($T_O$) with corresponding predefined threshold values ($T_{OL}$, $T_{OH}$);
- generating additional diagnostic information ($D_{SA}$) related to the operating conditions of said coil actuator and said switching apparatus based on a result of said comparison.

10. An electrical system (100) for low or medium voltage applications comprising:

    - one or more switching apparatuses (10);
    - one or more coil actuators (1), each operatively coupled to or included in a corresponding switching apparatus;
    - at least a supervisor unit (20), according to one or more of the previous claims, for controlling one or more coil actuators (1) of said electrical system.

EP 4 571 807 A1

Fig. 1

Fig. 2

Fig. 3

$D_1 \rightarrow$ 501 $\dashrightarrow$ TP, QP

502 $\dashrightarrow$ P

503

504 $\rightarrow D_S$

Fig.4

Fig. 5

Fig. 6

Europäisches
Patentamt

European
Patent Office

Office européen
des brevets

**EUROPEAN SEARCH REPORT**

Application Number

EP 23 21 6764

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2020/105448 A1 (TESTA MARCO [IT] ET AL) 2 April 2020 (2020-04-02) * page 2, paragraph 0037 - page 6, paragraph 0145; figures 1-5 * | 1-10 | INV. H01H47/00 ADD. H01H47/32 |
| Y | EP 3 018 678 A1 (ROCKWELL AUTOMATION TECH INC [US]) 11 May 2016 (2016-05-11) * page 17, paragraph 0082 - page 30, paragraph 0196; figures 25-41D, 46, 48, 71 * | 1-10 | |
| Y | US 2016/131712 A1 (BOCK CHRISTOPHER H [US] ET AL) 12 May 2016 (2016-05-12) * page 13, paragraph 0165 - page 24, paragraph 0280; figures 22, 25-41D, 46, 48 * | 1-10 | |
| Y | US 2018/174786 A1 (MATSUO NAOYUKI [JP] ET AL) 21 June 2018 (2018-06-21) * page 3, paragraph 0037 - page 7, paragraph 0091; figures 3-5D * | 1-10 | TECHNICAL FIELDS SEARCHED (IPC) H01H |

The present search report has been drawn up for all claims

| Place of search | Date of completion of the search | Examiner |
|---|---|---|
| Munich | 10 May 2024 | Pavlov, Valeri |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 4 571 807 A1**

## ANNEX TO THE EUROPEAN SEARCH REPORT
## ON EUROPEAN PATENT APPLICATION NO.

EP 23 21 6764

This annex lists the patent family members relating to the patent documents cited in the above-mentioned European search report.
The members are as contained in the European Patent Office EDP file on
The European Patent Office is in no way liable for these particulars which are merely given for the purpose of information.

10-05-2024

| Patent document cited in search report | | | Publication date | Patent family member(s) | | | Publication date |
|---|---|---|---|---|---|---|---|
| US 2020105448 | A1 | | 02-04-2020 | CN | 110957102 | A | 03-04-2020 |
| | | | | EP | 3629346 | A1 | 01-04-2020 |
| | | | | US | 2020105448 | A1 | 02-04-2020 |
| EP 3018678 | A1 | | 11-05-2016 | CN | 105589009 | A | 18-05-2016 |
| | | | | EP | 3018678 | A1 | 11-05-2016 |
| | | | | US | 2016134205 | A1 | 12-05-2016 |
| US 2016131712 | A1 | | 12-05-2016 | US | 2016131712 | A1 | 12-05-2016 |
| | | | | US | 2016133411 | A1 | 12-05-2016 |
| | | | | US | 2016133412 | A1 | 12-05-2016 |
| | | | | US | 2016133414 | A1 | 12-05-2016 |
| | | | | US | 2016133417 | A1 | 12-05-2016 |
| | | | | US | 2016134207 | A1 | 12-05-2016 |
| | | | | US | 2016134209 | A1 | 12-05-2016 |
| | | | | US | 2016134224 | A1 | 12-05-2016 |
| | | | | US | 2018067166 | A1 | 08-03-2018 |
| | | | | US | 2019025375 | A1 | 24-01-2019 |
| US 2018174786 | A1 | | 21-06-2018 | CN | 107924787 | A | 17-04-2018 |
| | | | | EP | 3432335 | A1 | 23-01-2019 |
| | | | | JP | 6504312 | B2 | 24-04-2019 |
| | | | | JP | WO2017159070 | A1 | 26-07-2018 |
| | | | | US | 2018174786 | A1 | 21-06-2018 |
| | | | | WO | 2017159070 | A1 | 21-09-2017 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2149890 B1